(19) Europäisches Patentamt / European Patent Office / Office européen des brevets

(11) **EP 2 593 800 B1**

(12) **EUROPÄISCHE PATENTSCHRIFT**

(45) Veröffentlichungstag und Bekanntmachung des Hinweises auf die Patenterteilung:
**26.09.2018 Patentblatt 2018/39**

(21) Anmeldenummer: **11738665.6**

(22) Anmeldetag: **08.07.2011**

(51) Int Cl.:
*G01R 19/25* (2006.01)   *G01R 31/34* (2006.01)

(86) Internationale Anmeldenummer:
**PCT/EP2011/061668**

(87) Internationale Veröffentlichungsnummer:
**WO 2012/007393 (19.01.2012 Gazette 2012/03)**

(54) **VERFAHREN ODER SPANNUNGSERFASSUNGSSYSTEM ZUM ERMITTELN EINES KORREKTURPARAMETERS FÜR EINEN MESSKANAL UND ZUM ERFASSEN EINER KLEMMENSPANNUNG EINES ELEKTROMOTORS**

METHOD OR VOLTAGE DETECTION SYSTEM FOR DETERMINING A CORRECTION PARAMETER FOR A MEASUREMENT CHANNEL AND FOR DETECTING A TERMINAL VOLTAGE OF AN ELECTRIC MOTOR

PROCÉDÉ OU SYSTÈME DE DÉTECTION DE TENSION POUR DÉTERMINER UN PARAMÈTRE DE CORRECTION POUR UN CANAL DE MESURE ET POUR DÉTECTER UNE TENSION AUX BORNES D'UN MOTEUR ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.07.2010 DE 102010031430**

(43) Veröffentlichungstag der Anmeldung:
**22.05.2013 Patentblatt 2013/21**

(73) Patentinhaber: **Robert Bosch GmbH**
**70442 Stuttgart (DE)**

(72) Erfinder: **FRICKER, David**
**F-67240 Oberhoffen Sur Moder (FR)**

(56) Entgegenhaltungen:
**CH-A- 483 640     US-A1- 2004 095 089**
**US-B1- 6 591 200**

• **JOHN W FINCH ET AL: "Controlled AC Electrical Drives", IEEE TRANSACTIONS ON INDUSTRIAL ELECTRONICS, IEEE SERVICE CENTER, PISCATAWAY, NJ, USA, Bd. 54, Nr. 2, 1. Februar 2008 (2008-02-01), Seiten 481-491, XP011198772, ISSN: 0278-0046**

**Beschreibung**

Technisches Gebiet

Die vorliegende Erfindung betrifft im Allgemeinen Verfahren zum Messen einer Klemmenspannung an einer Anschlussklemme eines Elektromotors.

Stand der Technik

Im Stand der Technik werden beispielsweise Klemmenspannungen eines Elektromotors erfasst, um daraus die Drehzahl oder auch die exakte Position des Elektromotors bestimmen zu können. So ist beispielsweise bei DC-Motoren oder elektrisch kommutierten Motoren (EC-Motoren) bekannt, die Position und/oder die Drehzahl der Antriebswelle des Elektromotors ohne die Verwendung eines Positionsgebers, der beispielsweise direkt an der Antriebswelle angebracht ist, kostengünstig zu erfassen. Dazu ist ein Spannungserfassungssystem vorgesehen, das eine oder mehrere Klemmenspannungen erfasst und an eine Steuereinrichtung für die Ansteuerung des Elektromotors überträgt. Das Spannungserfassungssystem kann als integraler Bestandteil der Steuereinrichtung des Elektromotors oder separat ausgeführt sein.

Um die Elektromotoren mit unterschiedlichen Drehzahlen betreiben zu können, sind üblicherweise elektrische oder elektronische Schaltelemente, wie z.B. Relais oder Transistoren vorgesehen, über welche die jeweilige Anschlussklemme mit wenigstens einer Versorgungsspannung oder der Masse verbunden werden kann. Entsprechend kann durch ein gezieltes Umschalten der Schaltelemente an jeder Wicklung des Elektromotors für eine gewünschte Zeit eine gewünschte Spannung angelegt und darüber ein gewünschter Betriebsmodus eingestellt werden. Für den Betrieb von Elektromotoren sind verschiedene Schaltungsarten üblich (H-Brücke, 2H-, 3H-, B6-Schaltung), die sich jedoch hinsichtlich des An- und Abschaltens einer Spannung an der Anschlussklemme prinzipiell nicht unterscheiden. Aufgrund der Induktivität der Motorwicklungen und möglichen Spannungsabfällen zwischen der Versorgungsspannung bzw. Masse und der Anschlussklemme, z.B. Leitungsverlusten, entspricht die Spannung an der Anschlussklemme jedoch nicht exakt der angelegten Spannung, so dass eine explizite Erfassung der Klemmenspannung erforderlich ist, um daraus die Position und die Drehzahl der Antriebswelle bestimmen zu können.

Für die Erfassung der Klemmenspannung umfasst as Spannungserfassungssystem einen Messkanal, der eingangsseitig unmittelbar mit der jeweiligen Anschlussklemme verbunden ist, um die anliegende Spannung abzugreifen und an seinem Ausgang auszugeben. Dies kann sowohl durch eine rein analoge Beschaltung wie auch durch Verwendung eines Analog/Digital-Wandlers geschehen, der die erfasste Klemmenspannung als digitales Signal ausgibt. Allerdings wird die abgegriffene Klemmenspannung durch den Messkanal verfälscht, wodurch die exakte Bestimmung der Position und der Drehzahl der Antriebswelle des Elektromotors erschwert wird.

In der Technik ist bekannt, das statische Verhalten des Messkanals zu erfassen, um einen Korrekturparameter für das statische Verhalten des Messkanals, beispielsweise in Bezug auf eine Verstärkung und/oder eine systematische Messabweichung, zu ermitteln. Dieser Korrekturparameter kann verwendet werden, um das statische Verhalten des Messkanals zu kompensieren. Auch ist in der Technik bekannt, einen automatischen Abgleich des statischen Verhaltens des Messkanals durchzuführen.

Allerdings umfasst der Messkanal auch nichtlineare Elemente, wodurch die exakte Erfassung der Klemmenspannung erschwert wird. Dies betrifft zunächst parasitäre Kapazitäten oder Induktivitäten von linearen Bauelementen, jedoch können auch Kondensatoren und/oder Spulen explizit in dem Messkanal verwendet werden. Um diese nichtlinearen Abweichungen gering zu halten, werden Bauteile mit einer hohen Güte verwendet, wodurch die Erfassung der Klemmenspannung mit hohen Kosten verbunden ist. Teilweise werden auch aktive Bauelemente wie z.B. Operationsverstärker verwendet, um die Erfassung der Klemmenspannung mit der gewünschten Genauigkeit durchführen zu können, was mit einem großen Aufwand und ebenfalls hohen Kosten verbunden ist.

Die Druckschrift US 2004095089 zeigt ein Verfahren zur Steuerung einer elektrischen Maschine, wobei die Steuerung ein Soll-Wert eines Drehmoments empfängt, dies wiederum führt zu einem Geschwindigkeitswert in Abhängigkeit einer Drehzahl der elektrischen Maschine, die einen Phasenvorsprung aufweist, der für einen gewünschten Phasenwinkel steht. Damit wird eine Spannungsantwort auf den Drehmomentwert, auf den Geschwindigkeitswert und den Phasenvorsprung erzeugt.

Ausgehend vom dem genannten Stand der Technik ist es Aufgabe der vorliegenden Erfindung, ein Verfahren anzugeben, mit dem ein Korrekturparameter zur Kompensation der nichtlinearen Eigenschaften des Messkanals bestimmt werden kann. Eine weitere Aufgabe der vorliegenden Erfindung ist es, ein Verfahren zur Erfassung der Klemmenspannung eines Motors anzugeben, das ein kostengünstige und mit einer hohen Genauigkeit die Erfassung der Klemmenspannung durchführt.

Offenbarung der Erfindung

Diese Aufgaben werden durch das Verfahren zum Ermitteln eines Korrekturparameters für einen Messkanal gemäß Anspruch 1, durch das Verfahren zum Erfassen einer Klemmenspannung, dem Computerprogrammprodukt, der Vorrichtung zum Ermitteln eines Korrekturparameters, das Spannungserfassungssystem zum Erfassen wenigstens einer Klemmenspannung gemäß den nebengeordneten Ansprüchen gelöst.

Weitere Ausgestaltungen sind in den abhängigen Ansprüchen angegeben.

Gemäß einem ersten Aspekt ist ein Verfahren zum Ermitteln eines Korrekturparameters für einen Messkanal vorgesehen, der für die Messung einer Klemmenspannung mit einer Anschlussklemme eines Elektromotors verbunden ist, wobei

- die Anschlussklemme über Schaltelemente für die Ansteuerung des Elektromotors mit einem ersten Potential verbunden wird,
- die Anschlussklemme nach dem Erreichen eines eingeschwungenen Zustands des Messkanals durch Umschalten wenigstens eines Schaltelements mit einem zweiten, von dem ersten verschiedenen Potential verbunden wird,
- das dynamische Verhalten des Messkanals nach dem Verbinden mit dem zweiten Potential erfasst wird, und
- der Korrekturparameter für das dynamische Verhalten des Messkanals basierend auf dessen erfassten dynamischen Verhalten bestimmt wird.

Grundidee des obigen Verfahrens ist es also, die vorhandenen Schaltelemente zur Ansteuerung des Motors zu verwenden, um an dem Messkanal einen Spannungssprung anzulegen und die Reaktion des Messkanals als Sprungantwort zu erfassen. Die Art der Spannungsänderung ist dabei unerheblich und kann von einem hohen zu einem niedrigen Potential oder umgekehrt erfolgen, wobei ein Potential auch die Masse sein kann. Aus der Sprungantwort ergibt sich das dynamische Verhalten des Messkanals und es kann darauf basierend ein Korrekturparameter für das dynamische Verhalten des Messkanals bestimmt werden. Der Korrekturparameter kann einen einzelnen Wert wie auch einen Satz einzelner Parameterwerte, der in seiner Gesamtheit das dynamische Verhalten des Messkanals beschreibt, umfassen. Basierend auf dem Korrekturparameter kann bei dem Messkanal im Betrieb eine Kompensation der erfassten Messwerte für die Klemmenspannung durchgeführt werden, wodurch die Klemmenspannung unter Berücksichtigung des dynamischen Verhaltens des Messkanals mit einer hohen Genauigkeit bestimmt werden kann.

In einer Ausgestaltung umfasst das Erfassen des dynamischen Verhaltens des Messkanals das Abtasten eines zeitlichen Verlaufs eines Ausgangssignals des Messkanals. Die so erfassten diskreten Werte geben in Ihrer Gesamtheit den Verlauf der Spannung am Ausgang des Messkanals wieder und können leicht elektronisch verarbeitet werden.

Insbesondere kann der Korrekturparameter als Filterparameter zur Durchführung einer Filterung des Ausgangssignals des Messkanals bestimmt werden. Abhängig von der Art des Ausgangssignals des Messkanals als analoges oder digitales kann sowohl ein analoges Filter oder auch ein digitales Filter verwendet werden. Das Filter kann beispielsweise als Tiefpassfilter ausgebildet sein, um ein entsprechendes Tiefpassverhalten basierend auf dem Filterparameter zu realisieren.

In einer weiteren Ausgestaltung umfasst die digitale Filterung eine IIR-Filterung (Infinite Impulse Response Filterung). Die IIR-Filterung kann sowohl analog wie auch digital durchgeführt werden.

In einer weiteren Ausgestaltung der Erfindung kann das erste und/oder zweite Potential gemessen und der Korrekturparameter für das dynamische Verhalten des Messkanals unter Einbeziehung der Messung des ersten und/oder zweiten Potentials bestimmt werden, um die Genauigkeit der Erfassung des Korrekturparameters zu verbessern.

Auch kann das dynamische Verhalten des zweiten Potentials erfasst und der Korrekturparameter für das dynamische Verhalten des Messkanals unter Einbeziehung des dynamischen Verhaltens des zweiten Potentials bestimmt werden. Schwankungen am Eingang des Messkanals können somit erfasst und bei der Bestimmung des Korrekturparameters berücksichtigt werden.

Insbesondere kann das Erfassen des dynamischen Verhaltens des zweiten Potentials das Abtasten eines zeitlichen Verlaufs des zweiten Potentials umfassen. Die so erfassten diskreten Werte geben in Ihrer Gesamtheit den exakten Verlauf der Klemmenspannung am Eingang des Messkanals wieder und können leicht elektronisch verarbeitet werden.

Auch kann das dynamische Verhalten eines oder mehrere Messkanäle an der vorhandenen Dynamik eines einzelnen Messkanals, der als Referenz dient, angepasst werden.

In weiterer Ausgestaltung der Erfindung kann das Erfassen des dynamischen Verhaltens des Messkanals das dynamische Erfassen eines Stroms von der Anschlussklemme in den Elektromotor umfassen und der Korrekturparameter unter Berücksichtigung des dynamisch erfassten Stroms bestimmt werden. Entsprechend können ausschließlich in dem Messkanal anliegende Spannungen bzw. dadurch fließende Ströme berücksichtig werden, um den Korrekturparameter mit einer hohen Genauigkeit bestimmen zu können.

Gemäß einer weiteren Ausführungsform kann die Anschlussklemme vor dem Verbinden mit dem zweiten Potential elektrisch von dem Elektromotor getrennt und nach dem Erfassen des dynamischen Verhaltens des Messkanals elektrisch mit dem Elektromotor verbunden werden. Damit werden Ströme von der Anschlussklemme in den Motor verhindert, die dynamisch aufgrund der Induktivität und ggf. weiterer nichtlinearer Komponenten des Elektromotors auftreten können.

Weiterhin kann wenigstens ein Korrekturparameter für das statische Verhalten, insbesondere eine Verstärkung und/oder eine systematischen Messabweichung des Messkanals erfasst werden, indem

- die Anschlussklemme über die Schaltelemente mit dem ersten Potential verbunden wird,
- das statische Verhalten des Messkanals nach dem Erreichen eines eingeschwungenen Zustands erfasst wird,
- die Anschlussklemme über die Schaltelemente mit dem zweiten Potential verbunden wird,
- das statische Verhalten des Messkanals nach dem Erreichen eines eingeschwungenen Zustands erfasst wird,
- der wenigstens eine Korrekturparameter für das statische Verhalten des Messkanals basierend auf dessen erfassten statischen Verhalten bestimmt werden.

Die Kombination von statischem und dynamischem Verhalten ergibt eine umfassende Beschreibung des Verhaltens des Messkanals, so dass die Klemmenspannung des Elektromotors bei einer Kompensation des Verhaltens des Messkanals mit einer hohen Genauigkeit erfasst werden kann.

Gemäß einem weiteren Aspekt ist eine Vorrichtung zum Ermitteln eines Korrekturparameters für das dynamische Verhalten eines Messkanals vorgesehen, der für die Messung einer Klemmenspannung mit einer Anschlussklemme eines Elektromotors verbunden ist, mit

- einer Schalteinheit für die Betätigung von Schaltelementen für die Ansteuerung des Elektromotors,
- einer Erfassungseinheit für die Erfassung wenigstens eines zeitlichen Spannungsverlaufs, und
- einer Steuerungsvorrichtung, die die Schalteinheit ansteuert und mit der Erfassungseinheit verbunden ist, um von dieser den wenigstens einen erfassten Spannungsverlauf zu empfangen, wobei die Steuerungsvorrichtung ausgeführt ist, den Korrekturparameter nach einem der vorgenannten Verfahren zu erfassen.

Diese Vorrichtung kann für die Bestimmung des Korrekturparameters mit Anschlussklemmen, Messkanälen und Schaltelementen verbunden werden, um den Korrekturparameter zu bestimmen. Es ist auch möglich, dass der Elektromotor oder eine damit verbundene Steuereinrichtung ein einzelnes Interface für die Verbindung der erfindungsgemäßen Vorrichtung mit den oben genannten Anschlüssen aufweist, so dass die Vorrichtung mit einem einzelnen Stecker verbunden werden kann. Die Steuereinrichtung umfasst die Spannungsmesseinrichtung mit den einzelnen Messkanälen oder ist mit dieser verbunden, um deren Ausgangssignale zu empfangen. Wenn das Interface an der Steuereinrichtung vorgesehen ist, kann der Korrekturparameter nach der Bestimmung in der Spannungsmesseinrichtung gespeichert oder an eine separate Kompensationsvorrichtung für die Kompensation des jeweiligen Messkanals übertragen werden.

Gemäß einem weiteren Aspekt ist ein Spannungserfassungssystem zum Erfassen wenigstens einer Klemmenspannung eines Elektromotors vorgesehen. Das Spannungserfassungssystem umfasst wenigstens einen Messkanal, der eingangsseitig mit einer Anschlussklemme des Elektromotors verbunden ist und an seinem Ausgang die erfasste Klemmenspannung bereitstellt, wobei das Spannungserfassungssystem eine oben beschrieben Vorrichtung für das Ermitteln von einem Korrekturparameter für das dynamische Verhalten wenigstens eines Messkanals umfasst und eine Kompensationsvorrichtung vorgesehen ist, die ausgeführt ist, das dynamische Verhalten des wenigstens einen Messkanals mit dem ermittelten Korrekturparameter zu kompensieren. Die Vorrichtung für die Bestimmung des Korrekturparameters ist somit integraler Bestandteil des Spannungserfassungssystems, wodurch die Bestimmung des Korrekturparameters jederzeit ohne zusätzliche Komponenten durchgeführt werden kann, beispielsweise durch ein Kommando der Steuereinrichtung des Elektromotors. Damit ist es möglich, die Kompensation des dynamischen Verhaltens des Messkanals beispielsweise bei Temperaturschwankungen, die eine Änderung der Bauteileigenschaften mit sich bringen, oder Alterungseffekten einzelner Komponenten jederzeit erneut durchzuführen.

In bevorzugter Ausführungsform der Erfindung ist die Steuerungsvorrichtung eine digitale Steuerungsvorrichtung, und die Verfahren sind als Computerprogrammprodukt implementiert, wobei die einzelnen Verfahrensschritte von der digitalen Steuerungsvorrichtung ausgeführt werden.

Weitere vorteilhafte Ausgestaltungen der Erfindung ergeben sich aus den Unteransprüchen sowie der Beschreibung eines Ausführungsbeispiels anhand der beigefügten Zeichnung.

Kurzbeschreibung der Zeichnungen

Ausführungsformen werden nachfolgend in Verbindung mit der beigefügten Zeichnung näher erläutert. Es zeigt:

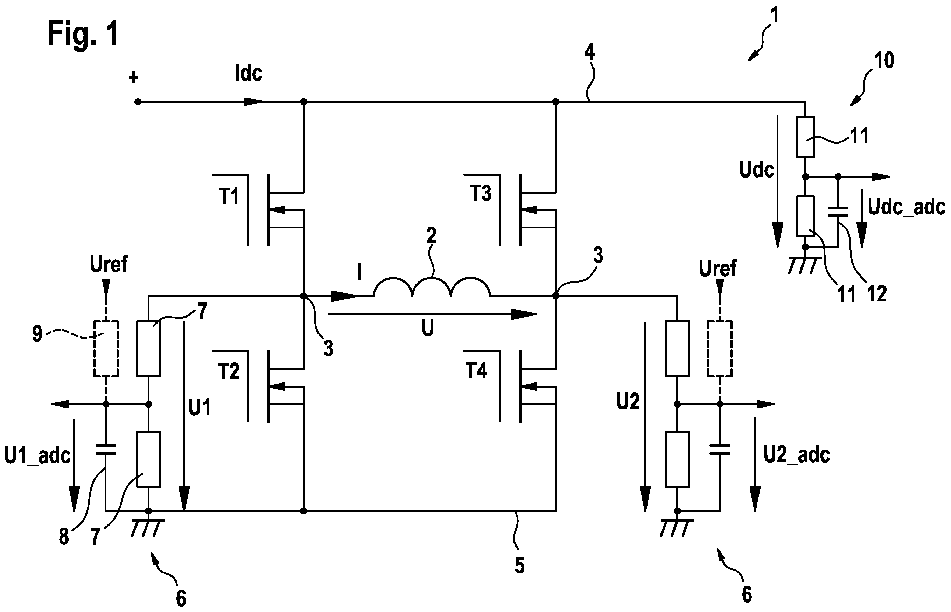

Figur 1    ein Schaltbild einer Schaltungsanordnung mit einem Motor, Schaltelementen zur Ansteuerung des Motors und zwei Messvorrichtungen zur Messung einer Klemmenspannung.

Beschreibung von Ausführungsformen

Figur 1 zeigt eine Schaltungsanordnung 1, in der ein Elektromotor 2 mit zwei Anschlussklemmen 3 zentral angeordnet ist. Der Strom durch den Elektromotor 2 ist als I und die daran abfallende Spannung als U gekennzeichnet. Der Elektromotor 2 ist in dieser Ausführungsform als Gleichstrommotor ausgeführt und in einer H-Brückenschaltung mit einer Versorgungsleitung 4 und einer Masseleitung 5 verbunden. Dabei ist zwischen jeder Anschlussklemme 3 und der Versorgungsleitung 4 ein erstes Schaltelement in der Form eines Transistors T1, T3 und zwischen jeder Anschlussklemme 3 und der Masseleitung 5 ein zweites Schaltelement in der Form eines Transistors T2, T4 vorgesehen. Die Transistoren T1, T2, T3, T4 werden als Schalter zwischen den Betriebszuständen leitend und sperrend betrieben, wobei eine nicht gezeigte Steuereinrichtung die Transistoren im Betrieb schaltet.

Jede Anschlussklemme 3 ist mit einem Messkanal 6 verbunden. Der mit der in der Figur linksseitigen Anschlussklemme 3 verbundene Messkanal 6 liegt eingangsseitig auf einem Potential U1, welches einer Klemmenspannung an der linksseitigen Anschlussklemme 3 entspricht, und liefert ausgangsseitig eine Spannung U1_adc. Der mit der in der Figur linksseitigen Anschlussklemme 3 verbundene Messkanal 6 liegt eingangsseitig auf einem Potential U2, welches einer Klemmenspannung an der linksseitigen Anschlussklemme 3 entspricht, und liefert ausgangsseitig eine Spannung U2_adc.

Die Messkanäle 6 sind prinzipiell identisch aufgebaut und hier beispielhaft durch zwei Widerstände 7 und einen Kondensator 8 dargestellt. Der Aufbau der Messkanäle 6 ist jedoch im weiteren nicht relevant, es soll lediglich dargestellt werden, dass in dem Messkanal 6 auch nichtlineare Komponenten vorhanden sind, entweder durch den hier explizit dargestellten Kondensator 8 oder durch parasitäre Kapazitäten und/oder Induktivitäten. Auch kann der Messkanal 6 aktive Komponenten enthalten, wie durch einen gestrichelt gezeichneten Widerstand 9, der an eine Referenzspannung Uref angeschlossen ist, angedeutet ist. So können beispielsweise auch Operationsverstärker in jedem Messkanal 6 vorhanden sein. Auch ist es nicht notwendig, dass beide Messkanäle 6 identisch aufgebaut sind.

An der Versorgungsleitung 4 ist eine Versorgungsspannung Udc angelegt, die eine stabilisierte Zwischenkreisspannung ist. Die Zwischenkreisspannung Udc lässt reduziert eine Rückwirkung auf ein Eingangsnetz. Mit der Versorgungsleitung 4 ist eine Messschaltung 10, die hier beispielhaft durch zwei Widerstände 11 und einen Kondensator 12 dargestellt ist, verbunden. Sie liefert ausgangsseitig eine Spannung Udc_adc, die ein Maß für die Zwischenkreisspannung Udc ist.

Nachfolgend wird nun das Verfahren für das Ermitteln von einem Korrekturparameter zur Kompensation des Verhaltens des Messkanals 6 beschrieben. Soweit das Verfahren auf beide Messkanäle 6 identisch angewendet wird, wird das Verfahren nur für den in der Figur linksseitigen Messkanal 6 explizit angegeben und gelten für den anderen Messkanal 6 entsprechend. Daher beziehen sich im Weiteren alle Angaben, soweit nicht anders angegeben, auf die in der Figur links von dem Elektromotor 2 gezeigten Elemente. Das Verfahren wird von einer nicht gezeigten Steuerungsvorrichtung durch das Abarbeiten einer Software durchgeführt.

In diesem Ausführungsbeispiel wird zunächst ein Korrekturparameter für das statische Verhalten des Messkanals 6 erfasst. Dazu wird zunächst über eine nicht gezeigte Erfassungseinheit, die mit der Steuerungsvorrichtung verbunden ist, die die Zwischenkreisspannung Udc am Ausgang der Messschaltung 10 erfasst. Dann werden von einer hier nicht gezeigten Schalteinheit, die von der Steuerungsvorrichtung angesteuert wird, das erste Schaltelement, der Transistor T1, auf leitend und das zweite Schaltelement, der Transistor T2, auf sperrend geschaltet. Nachdem sich ein eingeschwungener Zustand eingestellt hat, liegt eingangsseitig an dem Messkanal 6 die Versorgungsspannung Udc an, die Klemmenspannung U1 ist also gleich Udc. In diesem Zustand wird die Spannung U1_adc von der Erfassungseinheit an dem Ausgang des Messkanals 6 erfasst. Dann werden von der Schalteinheit der Transistor T1 auf sperrend und der Transistor T2 auf leitend geschaltet. Nachdem sich ein eingeschwungener Zustand eingestellt hat, liegt der Messkanal 6 eingangsseitig auf Masse, die Klemmenspannung U1 ist also gleich 0. Entsprechend ergibt sich für die Klemmenspannung U1 der in Gleichung 1.1 gezeigte Zusammenhang.

$$U1 = \frac{U1\_adc - U1\_adc(U1{=}0)}{U1\_adc(U1{=}Udc) - U1\_adc(U1{=}0)} \cdot Udc(U1{=}Udc) \qquad 1.1$$

Davon ausgehend wird in der Steuerungsvorrichtung ein Korrekturparameter für das statische Verhalten des Messkanals 6 bestimmt. Der Korrekturparameter umfasst zwei einzelne Parameterwerte, eine Verstärkung (Gain) und eine systematische Messabweichung (Bias), wobei sich der in Gleichung 1.2 dargestellte Zusammenhang ergibt.

$$U1 = U1\_adc \cdot Gain + Bias \qquad\qquad 1.2$$

Durch Umformen ergeben sich die Gleichung 1.3 für die Verstärkung und Gleichung 1.4 für die systematische Messabweichung.

$$Gain = \frac{Udc(U1=Udc)}{U1\_adc(U1=Udc) - U1\_adc(U1=0)} \qquad\qquad 1.3$$

$$Bias = - U1\_adc(U1=0) \cdot Gain \qquad\qquad 1.4$$

Dieser Korrekturparameter wird auf identische Weise für den in der Figur rechtsseitigen Messkanal 6 erfasst. Zusätzlich wird in der Steuerungsvorrichtung ein Abgleich der erfassten Werte für die Verstärkung und die systematische Messabweichung zwischen den beiden Messkanälen 6 durchgeführt. Entsprechend werden von beiden Messkanälen 6 die gleichen Werte ausgegeben, wenn an der jeweiligen Anschlussklemme 3 die Zwischenkreisspannung Udc bzw. Masse anliegt. Dies wird beispielsweise durch eine Mittelung zwischen den beiden Messkanälen 6 erreicht.

Im Anschluss wird das Verfahren für das Ermitteln eines Korrekturparameters für das dynamische Verhalten des Messkanals 6 beschrieben. Dazu wird zunächst von der Steuerungsvorrichtung über die Schalteinheit der Transistor T1 auf sperrend und der Transistor T2 auf leitend geschaltet, so dass die Anschlussklemme 3 mit der Masseleitung 5 verbunden ist und auf Massepotential liegt. Nachdem sich ein eingeschwungener Zustand eingestellt hat, wird der Transistor T1 von der Schalteinheit auf leitend und der Transistor T2 auf sperrend geschaltet, so dass die Anschlussklemme 3 mit der Versorgungsleitung 4 verbunden ist.

Nach dem Umschalten wird das dynamische Verhalten des Messkanals 6 erfasst, indem die Ausgangsspannung U1_adc von der Erfassungseinheit abgetastet wird. Zusätzlich wird auch das dynamische Verhalten der Zwischenkreisspannung Udc von der Erfassungseinheit durch Abtasten erfasst. Die Zwischenkreisspannung Udc liegt nach dem Umschalten an der Anschlussklemme 3 an und ist somit gleich der Klemmenspannung U1. Die Abtastwerte werden von der Erfassungseinheit an die Steuerungsvorrichtung übertragen.

Im Anschluss wird von der Steuerungsvorrichtung ein Korrekturparameter für das dynamische Verhalten des Messkanals 6 bestimmt. Dies wird hier beispielhaft für ein Tiefpassfilter erster Ordnung gezeigt. Das jeweils zu verwendende Filter ist abhängig von dem Messkanal 6. Das verwendete Tiefpassfilter ist ein IIR-Filter (Infinite Impulse Response Filter), das in allgemeiner Form gemäß Gleichung 1.5 dargestellt wird.

$$y_k = \lambda \cdot u_k + (1-\lambda) \cdot y_{k-1} \qquad\qquad 1.5$$

Dabei bedeutet:

$y_k$: Ausgangssignalreihe (U1_adc)
$x_k$: Eingangssignalreihe (Udc)
$\lambda$: Zeitkonstantenkoeffizient

Der Zeitkonstantenkoeffizient lässt sich gemäß Gleichung 1.6 angeben zu

$$\lambda = 1 - \exp\left(-\frac{Ts}{\tau}\right), \qquad\qquad 1.6$$

wobei Ts die Abtastzeit und $\tau$ die Zeitkonstante bedeuten. Aufgelöst nach dem Zeitkonstantenkoeffizient $\lambda$ ergibt sich der Zusammenhang aus Gleichung 1.7.

$$\lambda_k = \frac{U1_k - U1_{k-1}}{Udc_{k-1} - U1_{k-1}} \qquad\qquad 1.7$$

Unter der Annahme, dass $\lambda_k$ konstant ist, lässt sich der Zeitkonstantenkoeffizient $\lambda$ durch Mittelung über mehrere Abtastzeitpunkte bestimmen, wie in Gleichung 1.8 gezeigt ist.

$$\lambda = \frac{1}{N} \cdot \sum_{1}^{N} \lambda_k$$

1.8

Der Zeitkonstantenkoeffizient $\lambda$ beschreibt somit das dynamische Verhalten des Messkanals 6 und lässt sich als Korrekturparameter verwenden. Dazu wird die Schaltungsanordnung 1 um ein hier nicht gezeigtes IIR-Filter für den jeweiligen Messkanal 6 ergänzt. Entsprechend kann ein angepasstes Signal U1' mit einer gewünschten Dynamik $\lambda$', wie in Gleichung 1.9 angegeben, gebildet werden.

$$U1'_k = \alpha \cdot U1_k + (\lambda' - \alpha) \cdot U1_{k-1} + (\lambda' - 1) \cdot U1'_{k-1}$$

1.9

Dabei ist $\alpha = \lambda'$ / $\lambda$.
Somit kann zusätzlich das nichtlineare Verhalten des Messkanals 6 mit Hilfe des IIR-Filters kompensiert werden, wodurch sich die Klemmenspannung U1 mit einer hohen Genauigkeit bestimmen lässt. Das nichtlineare Verhalten ist unabhängig für jeden Messkanal 6, so dass hier keine weitere Kompensation zwischen den beiden Messkanälen 6 erforderlich ist.
In der gezeigten Ausführungsform sind die Schalteinheit, die Erfassungseinheit und die Steuerungsvorrichtung in einer Vorrichtung für das Ermitteln von einem Korrekturparameter für das dynamische Verhalten eines Messkanals zusammengefasst.
Ein Spannungserfassungssystem für das Erfassen wenigstens einer Klemmenspannung U1, U2 des Elektromotors 2 umfasst die Vorrichtung für das Ermitteln von einem Korrekturparameter für das dynamische Verhalten der Messkanäle 6, die Messkanäle 6 sowie das jedem Messkanal 6 zugeordnete IIR-Filter. Die Übertragung des jeweiligen Zeitkonstantenkoeffizienten $\lambda$ wird von der Steuerungsvorrichtung automatisch durchgeführt. Das Spannungserfassungssystem ist mit der Steuereinrichtung verbunden und liefert dieser im Betrieb die erfassten Werte der Klemmenspannungen U1, U2.

**Patentansprüche**

1. Verfahren zum Ermitteln eines Korrekturparameters für einen Messkanal (6), der für die Messung einer Klemmenspannung (U1, U2) mit einer Anschlussklemme (3) eines Elektromotors (2) verbunden ist, **dadurch gekennzeichnet, dass**

    - die Anschlussklemme (3) über Schaltelemente (T1, T2, T3, T4) für die Ansteuerung des Elektromotors (2) mit einem ersten Potential verbunden wird,
    - die Anschlussklemme (3) nach dem Erreichen eines eingeschwungenen Zustands des Messkanals (6) durch Umschalten wenigstens eines Schaltelements (T1, T2, T3, T4) mit einem zweiten, von dem ersten verschiedenen Potential verbunden wird,
    - das dynamische Verhalten des Messkanals (6) nach dem Verbinden mit dem zweiten Potential erfasst wird, und
    - der Korrekturparameter für das dynamische Verhalten des Messkanals (6) basierend auf dessen erfassten dynamischen Verhalten bestimmt wird.

2. Verfahren nach Anspruch 1, **dadurch gekennzeichnet, dass** das Erfassen des dynamischen Verhaltens des Messkanals (6) das Abtasten eines zeitlichen Verlaufs eines Ausgangssignals (U1_adc, U2_adc) des Messkanals (6) umfasst.

3. Verfahren nach einem der Ansprüche 1 oder 2, **dadurch gekennzeichnet, dass** der Messkanal (6) einen Ausgang aufweist und der Korrekturparameter als Filterparameter zur Durchführung einer digitalen Filterung des Ausgangssignals des Messkanals (6) bestimmt wird.

4. Verfahren nach Anspruch 3, **dadurch gekennzeichnet, dass** die digitale Filterung eine IIR-Filterung (Infinite Impulse Response Filterung) umfasst.

5. Verfahren nach einem der vorhergehenden Ansprüche, **dadurch gekennzeichnet, dass** das erste und/oder zweite Potential gemessen und der Korrekturparameter für das dynamische Verhalten des Messkanals (6) unter Einbeziehung der Messung des ersten und/oder zweiten Potentials bestimmt werden.

6. Verfahren nach einem der vorhergehenden Ansprüche, **dadurch gekennzeichnet, dass** das dynamische Verhalten des zweiten Potentials erfasst und der Korrekturparameter für das dynamische Verhalten des Messkanals (6) unter Einbeziehung des dynamischen Verhaltens des zweiten Potentials bestimmt wird.

7. Verfahren nach Anspruch 6, **dadurch gekennzeichnet, dass** das Erfassen des dynamischen Verhaltens des zweiten Potentials das Abtasten eines zeitlichen Verlaufs des zweiten Potentials umfasst.

8. Verfahren nach einem der vorhergehenden Ansprüche, **dadurch gekennzeichnet, dass** das dynamische Verhalten eines weiteren Messkanals (6), der als Referenz dient, erfasst und der Korrekturparameter für das dynamische Verhalten des Messkanals (6) unter Einbeziehung des dynamischen Verhaltens des Referenz Messkanals (6) bestimmt wird, um das dynamische Verhalten anzugleichen.

9. Verfahren nach Anspruch 8, **dadurch gekennzeichnet, dass** das Erfassen des dynamischen Verhaltens des weiteren Messkanals (6), der als Referenz dient, das Abtasten eines zeitlichen Verlaufs des Referenz Messkanals (6) umfasst.

10. Verfahren nach einem der vorhergehenden Ansprüche, **dadurch gekennzeichnet, dass** das Erfassen des dynamischen Verhaltens des Messkanals (6) das dynamische Erfassen eines Stroms (I) von der Anschlussklemme (3) in den Elektromotor (2) umfasst und der Korrekturparameter unter Berücksichtigung des dynamisch erfassten Stroms (I) bestimmt wird.

11. Verfahren nach einem der Ansprüche 1 bis 10, **dadurch gekennzeichnet, dass** die Anschlussklemme (3) vor dem Verbinden mit dem zweiten Potential elektrisch von dem Elektromotor (2) getrennt und nach dem Erfassen des dynamischen Verhaltens des Messkanals (6) elektrisch mit dem Elektromotor (2) verbunden wird.

12. Verfahren nach einem der vorhergehenden Ansprüche, **dadurch gekennzeichnet, dass** wenigstens ein Korrekturparameter für das statische Verhalten, insbesondere eine Verstärkung und/oder eine systematischen Messabweichung des Messkanals (6) erfasst werden, indem

- die Anschlussklemme (3) über die Schaltelemente (T1, T2, T3, T4) mit dem ersten Potential verbunden wird,
- das statische Verhalten des Messkanals (6) nach dem Erreichen eines eingeschwungenen Zustands erfasst wird,
- die Anschlussklemme (3) über die Schaltelemente (T1, T2, T3, T4) mit dem zweiten Potential verbunden wird,
- das statische Verhalten des Messkanals (6) nach dem Erreichen eines eingeschwungenen Zustands erfasst wird,
- der wenigstens eine Korrekturparameter für das statische Verhalten des Messkanals (6) basierend auf dessen erfassten statischen Verhalten bestimmt werden.

13. Verfahren zum Erfassen einer Klemmenspannung (U1, U2) eines Elektromotors (2), wobei die Klemmenspannung (U1, U2) an einer Anschlussklemme (3) des Elektromotors (2) abgegriffen und am Ausgang eines Messkanals (6) bereitgestellt wird, **dadurch gekennzeichnet, dass** ein Korrekturparameter für den Messkanal (6) nach dem Verfahren nach einem der vorhergehenden Ansprüche bestimmt wird und das dynamische Verhalten des Messkanals (6) mit dem ermittelten Korrekturparameter kompensiert wird.

14. Vorrichtung zum Ermitteln eines Korrekturparameters für das dynamische Verhalten eines Messkanals (6), der für die Messung einer Klemmenspannung (U1, U2) mit einer Anschlussklemme (3) eines Elektromotors (2) verbunden ist, **dadurch gekennzeichnet, dass** die Vorrichtung

- eine Schalteinheit für die Betätigung von Schaltelementen (T1, T2, T3, T4) für die Ansteuerung des Elektromotors (2),
- eine Erfassungseinheit für die Erfassung wenigstens eines zeitlichen Spannungsverlaufs, und
- eine Steuerungsvorrichtung, die die Schalteinheit ansteuert und mit der Erfassungseinheit verbunden ist, um von dieser den wenigstens einen erfassten Spannungsverlauf zu empfangen, wobei die Steuerungsvorrichtung ausgeführt ist, den Korrekturparameter nach einem der Verfahren der Ansprüche 1 bis 10 zu erfassen,

umfasst.

**15.** Vorrichtung nach Anspruch 14 zum Erfassen wenigstens einer Klemmenspannung (U1, U2) eines Elektromotors (2) mit wenigstens einem Messkanal (6), der eingansseitig mit einer Anschlussklemme (3) des Elektromotors (2) verbunden ist und an seinem Ausgang die erfasste Klemmenspannung (U1, U2) bereitstellt, **dadurch gekennzeichnet, dass** das Spannungserfassungssystem eine Vorrichtung für das Ermitteln von einem Korrekturparameter für das dynamische Verhalten wenigstens eines Messkanals (6) nach Anspruch 13 umfasst und eine Kompensationsvorrichtung vorgesehen ist, die ausgeführt ist, das dynamische Verhalten des wenigstens einen Messkanals (6) mit dem ermittelten Korrekturparameter zu kompensieren.

**Claims**

**1.** Method for determining a correction parameter for a measurement channel (6) which is connected to a connection terminal (3) of an electric motor (2) in order to measure a terminal voltage (U1, U2), **characterized in that**

- the connection terminal (3) is connected to a first potential by means of switching elements (T1, T2, T3, T4) for driving the electric motor (2),
- the connection terminal (3) is connected to a second potential, which differs from the first, by switching over at least one switching element (T1, T2, T3, T4) after a steady state of the measurement channel (6) is reached,
- the dynamic response of the measurement channel (6) is detected after connection to the second potential, and
- the correction parameter for the dynamic response of the measurement channel (6) is determined on the basis of the detected dynamic response of said measurement channel.

**2.** Method according to Claim 1, **characterized in that** detecting the dynamic response of the measurement channel (6) comprises sampling a time profile of an output signal (U1_adc, U2_adc) of the measurement channel (6).

**3.** Method according to one of Claims 1 and 2, **characterized in that** the measurement channel (6) has an output and the correction parameter is determined as a filter parameter for digitally filtering the output signal of the measurement channel (6).

**4.** Method according to Claim 3, **characterized in that** digital filteringcomprises IIR filtering (Infinite Impulse Response filtering).

**5.** Method according to one of the preceding claims, **characterized in that** the first and/or second potential are/is measured and the correction parameter for the dynamic response of the measurement channel (6) is determined with the inclusion of the measurement of the first and/or second potential.

**6.** Method according to one of the preceding claims, **characterized in that** the dynamic response of the second potential is detected and the correction parameter for the dynamic response of the measurement channel (6) is determined with the inclusion of the dynamic response of the second potential.

**7.** Method according to Claim 6, **characterized in that** detecting the dynamic response of the second potential comprises sampling a time profile of the second potential.

**8.** Method according to one of the preceding claims, **characterized in that** the dynamic response of a further measurement channel (6), which serves as a reference, is detected and the correction parameter for the dynamic response of the measurement channel (6) is determined with the inclusion of the dynamic response of the reference measurement channel (6) in order to adjust the dynamic response.

**9.** Method according to Claim 8, **characterized in that** detecting the dynamic response of the further measurement channel (6), which serves as a reference, comprises sampling a time profile of the reference measurement channel (6).

**10.** Method according to one of the preceding claims, **characterized in that** detecting the dynamic response of the measurement channel (6) comprises dynamically detecting a current (I) from the connection terminal (3) into the electric motor (2) and the correction parameter is determined taking into account the dynamically detected current (I).

**11.** Method according to one of Claims 1 to 10, **characterized in that** the connection terminal (3) is electrically disconnected from the electric motor (2) before it is connected to the second potential and is electrically connected to the electric motor (2) after the dynamic response of the measurement channel (6) is detected.

**12.** Method according to one of the preceding claims, **characterized in that** at least one correction parameter for the static response, in particular a gain and/or a systematic measurement deviation, of the measurement channel (6) are/is detected by

- the connection terminal (3) being connected to the first potential by means of the switching elements (T1, T2, T3, T4),
- the static response of the measurement channel (6) being detected after a steady state is reached,
- the connection terminal (3) being connected to the second potential by means of the switching elements (T1, T2, T3, T4),
- the static response of the measurement channel (6) being detected after a steady state is reached,
- the at least one correction parameter for the static response of the measurement channel (6) being determined on the basis of the detected static response of said measurement channel.

**13.** Method for detecting a terminal voltage (U1, U2) of an electric motor (2), wherein the terminal voltage (U1, U2) is tapped off at a connection terminal (3) of the electric motor (2) and is provided at the output of a measurement channel (6), **characterized in that** a correction parameter for the measurement channel (6) is determined in line with the method according to one of the preceding claims, and the dynamic response of the measurement channel (6) is compensated by the determined correction parameter.

**14.** Apparatus for determining a correction parameter for the dynamic response of a measurement channel (6) which is connected to a connection terminal (3) of an electric motor (2) in order to measure a terminal voltage (U1, U2), **characterized in that** the apparatus comprises

- a switching unit for operating switching elements (T1, T2, T3, T4) for driving the electric motor (2),
- a detection unit for detecting at least one voltage profile with respect to time, and
- a control apparatus which drives the switching unit and is connected to the detection unit, in order to receive the at least one detected voltage profile from said detection unit, wherein the control apparatus is designed to detect the correction parameter in line with one of the methods of Claims 1 to 10.

**15.** Apparatus according to Claim 14 for detecting at least one terminal voltage (U1, U2) of an electric motor (2), having at least one measurement channel (6) which, at the input end, is connected to a connection terminal (3) of the electric motor (2) and provides the detected terminal voltage (U1, U2) at its output, **characterized in that** the voltage detection system comprises an apparatus for determining a correction parameter for the dynamic response of at least one measurement channel (6) according to Claim 13, and a compensation apparatus is provided which is designed to compensate the dynamic response of the at least one measurement channel (6) with the determined correction parameter.

**Revendications**

**1.** Procédé pour déterminer un paramètre de correction pour un canal de mesure (6), lequel est relié à une borne de raccordement (3) d'un moteur électrique (2) pour la mesure d'une tension de borne (U1, U2), **caractérisé en ce que**

- la borne de raccordement (3) est reliée à un premier potentiel par le biais d'éléments de commutation (T1, T2, T3, T4) pour l'excitation du moteur électrique (2),
- après avoir atteint un état de régime permanent du canal de mesure (6), la borne de raccordement (3) est reliée à un deuxième potentiel, différent du premier, par inversion d'au moins un élément de commutation (T1, T2, T3, T4),
- le comportement dynamique du canal de mesure (6) est détecté après la connexion au deuxième potentiel et
- le paramètre de correction pour le comportement dynamique du canal de mesure (6) est déterminé en se basant sur son comportement dynamique détecté.

**2.** Procédé selon la revendication 1, **caractérisé en ce que** la détection du comportement dynamique du canal de mesure (6) comprend l'échantillonnage d'une courbe dans le temps d'un signal de sortie (U1_adc, U2_adc) du canal de mesure (6).

3. Procédé selon l'une des revendications 1 ou 2, **caractérisé en ce que** le canal de mesure (6) possède une sortie et le paramètre de correction est déterminé en tant que paramètre de filtrage en vue de la réalisation d'un filtrage numérique du signal de sortie du canal de mesure (6).

4. Procédé selon la revendication 3, **caractérisé en ce que** le filtrage numérique comprend un filtrage IIR (filtrage à réponse impulsionnelle infinie).

5. Procédé selon l'une des revendications précédentes, **caractérisé en ce que** le premier et/ou le deuxième potentiel sont mesurés et le paramètre de correction pour le comportement dynamique du canal de mesure (6) est déterminé en intégrant la mesure du premier et/ou du deuxième potentiel.

6. Procédé selon l'une des revendications précédentes, **caractérisé en ce que** le comportement dynamique du deuxième potentiel est détecté et le paramètre de correction pour le comportement dynamique du canal de mesure (6) est déterminé en intégrant le comportement dynamique du deuxième potentiel.

7. Procédé selon la revendication 6, **caractérisé en ce que** la détection du comportement dynamique du deuxième potentiel comprend l'échantillonnage d'une courbe dans le temps du deuxième potentiel.

8. Procédé selon l'une des revendications précédentes, **caractérisé en ce que** le comportement dynamique d'un canal de mesure (6) supplémentaire qui sert de référence, est détecté et le paramètre de correction pour le comportement dynamique du canal de mesure (6) est déterminé en intégrant le comportement dynamique du canal de mesure (6) de référence afin de compenser le comportement dynamique.

9. Procédé selon la revendication 8, **caractérisé en ce que** la détection du comportement dynamique du canal de mesure (6) supplémentaire qui sert de référence comprend l'échantillonnage d'une courbe dans le temps du canal de mesure (6) de référence.

10. Procédé selon l'une des revendications précédentes, **caractérisé en ce que** la détection du comportement dynamique du canal de mesure (6) comprend la détection dynamique d'un courant (I) de la borne de raccordement (3) dans le moteur électrique (2) et le paramètre de correction est déterminé en tenant compte du courant (I) détecté dynamiquement.

11. Procédé selon l'une des revendications 1 à 10, **caractérisé en ce que** la borne de raccordement (3) est déconnectée électriquement du moteur électrique (2) avant la connexion au deuxième potentiel et reliée électriquement au moteur électrique (2) après la détection du comportement dynamique du canal de mesure (6).

12. Procédé selon l'une des revendications précédentes, **caractérisé en ce qu'**au moins un paramètre de correction pour le comportement statique est détecté, notamment une amplification et/ou un écart de mesure systématique du canal de mesure (6), **en ce que**

    - la borne de raccordement (3) est reliée au premier potentiel par le biais des éléments de commutation (T1, T2, T3, T4),
    - le comportement statique du canal de mesure (6) est détecté après avoir atteint un état de régime permanent,
    - la borne de raccordement (3) est reliée au deuxième potentiel par le biais des éléments de commutation (T1, T2, T3, T4),
    - le comportement statique du canal de mesure (6) est détecté après avoir atteint un état de régime permanent,
    - l'au moins un paramètre de correction pour le comportement statique du canal de mesure (6) est déterminé en se basant sur son comportement statique détecté.

13. Procédé de détection d'une tension de borne (U1, U2) d'un moteur électrique (2), la tension de borne (U1, U2) étant prélevée à une borne de raccordement (3) du moteur électrique (2) et délivrée à la sortie d'un canal de mesure (6), **caractérisé en ce qu'**un paramètre de correction pour le canal de mesure (6) est déterminé conformément au procédé selon l'une des revendications précédentes et le comportement dynamique du canal de mesure (6) est compensé avec le paramètre de correction déterminé.

14. Dispositif pour déterminer un paramètre de correction pour le comportement dynamique d'un canal de mesure (6), lequel est relié à une borne de raccordement (3) d'un moteur électrique (2) pour la mesure d'une tension de borne (U1, U2), **caractérisé en ce que** le dispositif comprend

- une unité de commutation destinée à actionner des éléments de commutation (T1, T2, T3, T4) pour l'excitation du moteur électrique (2),
- une unité de détection destinée à détecter au moins une courbe de tension dans le temps, et
- un dispositif de commande qui pilote l'unité de commutation et qui est relié à l'unité de détection pour recevoir de sa part l'au moins une courbe de tension dans le temps détectée, le dispositif de commande étant conçu pour détecter le paramètre de correction selon l'un des procédés des revendications 1 à 10.

15. Dispositif selon la revendication 14 pour la détection d'au moins une tension de borne (U1, U2) d'un moteur électrique (2), comprenant au moins un canal de mesure (6) dont l'entrée est reliée à une borne de raccordement (3) du moteur électrique (2) et qui délivre la tension de borne (U1, U2) détectée à sa sortie, **caractérisé en ce que** le système de détection de tension comprend un dispositif pour la détermination d'un paramètre de correction pour le comportement dynamique d'au moins un canal de mesure (6) selon la revendication 13 et il existe un dispositif de compensation qui est conçu pour compenser le comportement dynamique de l'au moins un canal de mesure (6) avec le paramètre de correction déterminé.

**Fig. 1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2004095089 A